# EUROPÄISCHE PATENTSCHRIFT

(11) **EP 1 619 937 B1**
(45) Veröffentlichungstag und Bekanntmachung des Hinweises auf die Patenterteilung: **26.03.2008**
(21) Anmeldenummer: 04017334.6
(22) Anmeldetag: 22.07.2004
(51) Int. Cl.: H05K 5/02

(54) **Gehäuse für ein elektrisches oder elektronisches Gerät**
Housing for an electrical or electronic apparatus
Boîtier pour un appareil électrique ou électronique

(43) Veröffentlichungstag der Anmeldung: 25.01.2006
(73) Patentinhaber: Landis+Gyr AG, 6300 Zug (CH)
(72) Erfinder: Amstad, Reto, 6343 Rotkreuz (CH)
(74) Vertreter: Lagler, Louis

(56) Entgegenhaltungen:
- EP-A- 0 740 370
- EP-A- 1 315 240
- DE-A- 19 910 203
- DE-U- 20 001 278

## Beschreibung

Die Erfindung stammt aus dem technischen Gebiet der Kunststofftechnik. Sie betrifft ein Gehäuse für ein elektrisches oder elektronisches Gerät nach dem Oberbegriff des Anspruchs 1.

Gehäuse für elektrische oder elektronische Geräte sind allgemein bekannt. Sie weisen eine den elektrischen oder elektronischen Bedingungen entsprechend geeignete Grösse auf, die eine im wesentlichen interne Installation beispielsweise von bestückten Platinen, Anzeigen jedweder Art, Speichermedien, Antrieben, Druckvorrichtungen, Kommunikationseinheiten oder Tastaturen erlauben.

Dabei werden gehäuseinterne Bedingungen sowie Umgebungsbedingungen des Gehäuseinstallationsortes zu Beispiel hinsichtlich der Betriebszustände, der Temperatur, der Feuchte, der Dichtigkeit gegenüber Staub und Wasser berücksichtig. Den jeweiligen Anwendungsbedingungen entsprechend werden an einer sichtbaren Aussenseite des Gehäuses Betriebszustände, Programmmenüs oder Messergebnisse zur Anzeige gebracht.

Für komplexere Darstellung dienen dabei vielfach LCD-Anzeigen. Bei der Signalisierung von Betriebszuständen sind einfache Lichtquellen jeder Art meist ausreichend. Mit Leuchtdioden (LED) sind einfache und preiswerte Lichtquelle gegeben, die sehr flexible installierbar sind und hinsichtlich Stückkosten und der Betriebskosten gegenüber anderen Lichtquellen mit Vorteil eingesetzt werden.

LEDs werden üblicherweise direkt auf Platinen installiert, wobei diese Platinen eine ihrem Einsatz entsprechende elektrische und/oder elektronische Bestückung aufweisen. Dabei sind häufig die Platinenfunktion und die Anzeige der der Platine eigenen Betriebszustände mittels LED unmittelbar nebeneinander angeordnet.

Die Bestückung von Platinen und auch die konstruktiven Bedingungen des Installationsortes bedingen aber, dass mit LEDs ausgestattete Platinen nicht immer in unmittelbarer Nachbarschaft einer von aussen gut sichtbaren Gehäusewand oder eines Gehäusedeckels angeordnet sein können, an denen entsprechende Ausnehmungen für die LEDs vorzusehen wären. Das heisst, dass solche LEDs demzufolge zwar funktionsnah auf einer Platine installiert sind, diese Platine mit ihren LEDs aber nicht so nahe an eine von aussen sichtbare Gehäusewand installiert werden kann, so dass ein externer Betrachter die LEDs gut sehen und darüber hinaus voneinander unterscheiden kann.

Um das ausgesendete Licht von solchen tiefer in einem Gehäuse installierten LEDs an eine sichtbare Gehäuseoberfläche zu transportieren gelangen bekanntermassen Lichtleiter zu Einsatz. Solche Lichtleiter transportieren dabei möglichst verlustfrei gebündelte Lichtstrahlen von LEDs zu geeigneten Anzeigebereichen von Gehäuseoberflächen.

Diese Lichtleiter sind häufig aus transparentem Kunststoff hergestellt und weisen polierte Lichtkanaloberflächen auf, damit eintreffendes und austretendes Licht nicht gestreut wird. Angeordnet sind diese Lichtleiter in unmittelbarer Nähe zur zugehörigen Lichtquelle. Dabei kann ein solcher Lichtleiter als eigenständiges Spritzgussteil an der Platine befestigt werden oder mit einer Gehäusewand oder einem Gehäusedeckel verbunden sein. Es sind auch Ausführungsvarianten bekannt, bei denen ein Lichtleiter einstückig mit einer Gehäusewand oder einem Gehäusedeckel im Spritzgiessverfahren hergestellt werden; vgl. z.B. EP-A-0 740 370 und EP-A-1 315 240.

Die DE 200 01 278.9 U1 zeigt beispielhaft eine einstückige Ausführungsform, bei der ein Lichtleiter mit einem Gehäusedeckel verbunden ist.

Besondere Anforderungen werden dabei an die Spritzgiesstechnik gestellt, um in einem Verfahrensschritt blasenfreie Lichtleiter an eine Gehäusewand oder einen Gehäusedeckel anzugiessen.

Darüber hinaus muss im Anzeigebereich der sichtbaren Gehäuseoberfläche eine meist folienartige Gehäusebeschriftung, auch Zifferblatt genannt, entsprechend den innen liegenden Lichtleitern Ausnehmungen ausweisen. Für die Herstellung von Gehäuseteilen und ihren Zifferblättern müssen deshalb Werkzeuge bereit gestellt werden, die entsprechend der Platzierung der LEDs auf einer im Gehäuse installierten Platine ausgestaltet sein müssen. Somit sind derartige Werkzeuge unmittelbar mit einem Gerätetyp verknüpft, da sie in unmittelbarem, funktionalem Zusammenhang zueinander stehen. Bei der Herstellung von Massenartikeln wie Gehäusen ist also hinsichtlich der internen LEDs eine jeweilige funktionsbedingte Typenanpassung nötig, die mit Kosten verbunden ist.

Ausgehend vom gattungsgemässen Stand der Technik liegt der Erfindung die Aufgabe zugrunde, ein Gehäuse für elektrische oder elektronische Geräte bereitzustellen, dass weitgehend unabhängig von der internen Funktionalität eine möglichst einfache Anzeige mittels in dem Gerät installierter Lichtquellen an einer sichtbare Oberfläche des Gehäuses ermöglicht.

Erfindungsgemäss wird diese Aufgabe durch die Merkmale des Anspruchs 1 gelöst. Weitere vorteilhafte Ausgestaltungen der Erfindung sind Gegenstand der abhängigen Ansprüche 2 bis 10.

Zur Lösung der der Erfindung zugrunde liegenden Aufgabe ist bei einem Gehäuse für elektrische oder elektronische Geräte vorgesehen, zumindest einen Teil einer Gehäusewand transparent auszuführen, so dass ausgesendetes Licht von einer Lichtquelle, das in diese Gehäusewand hineinstrahlt im wesentlichen parallel zu dieser Gehäusewand hindurchgeleitet wird.

Die Gehäusewand selbst übernimmt hierdurch die Funktion eines Lichtleiters für die Lichtquelle, die im Inneren des Gehäuses angeordnet ist. So können selbst Lichtquellen, die vergleichsweise tief im Inneren eines Gehäuses angeordnet sind durch eine Gehäusewand bis an eine aussen sichtbare Anzeigefläche einen Betriebszustand signalisieren, ohne dass diese Lichtquelle unmittelbar unter einem Gehäusedeckel angeordnet sein muss. Dadurch entfallen auch herkömmliche Lichtwellenleiter, die ausgesendetes Licht von Lichtquellen im Inneren des Gehäuses an die Gehäuseoberfläche transportieren

Selbst wenn hier lediglich davon die Rede ist, dass eine Gehäusewand oder ein Gehäusewandteil als Lichtleiter fungiert, so ist dies keinesfalls einschränkend zu betrachten. Selbstverständlich ist im Rahmen der Erfindung jede den Innenraum eines Gehäuses begrenzende Wand als eine Gehäusewand zu betrachten, die lichtleitend eingesetzt werden kann; das heisst, dass auch ein Gehäusedeckel ebenso erfindungsgemäss umfasst ist, wie ein Gehäuseboden.

Eine vorteilhafte Ausgestaltung der Erfindung sieht vor, dass eine Lichtquelle gegenüber einer Wandkante einer Gehäusewand oder eines Gehäusewandteils angeordnet ist und in die Gehäusewand einstrahlt. Von besonderer Bedeutung ist dabei, dass die Kante im Bereich der Lichteinstrahlung und eine Anzeigefläche an einer Gehäuseoberfläche zwecks optimaler Lichtausbeute zumindest teilweise poliert sind.

Bei einer weiteren vorteilhaften Ausgestaltung der Erfindung ist vorgesehen, die Lichtquelle seitlich zu einem Gehäusewandteil anzuordnen, wobei das Gehäusewandteil zumindest teilweise eine optisch wirksame Fläche aufweist, zwecks Brechung des eingestrahlten Lichts in dieses Gehäusewandteil im wesentlichen in paralleler Richtung zu diesem Gehäusewandteil. Hierfür kann beispielsweise eine Gehäusewandteilkante schräg zur Gehäusewand angeordnet sein und somit prismenartig als optische Fläche dienen, oder diese Gehäusewandteilkante zeigt eine konvexe Struktur. In beiden Fällen dient die Gehäusewandteilkante jedenfalls als optisch wirksame Fläche, durch die eingestrahltes Licht einer Lichtquelle gebeugt wird und die Lichtstrahlen parallel zur Gehäusewand ausgerichtet werden. Die Lichtstrahlen verlaufen dann durch die Gehäusewand bis zu einer Anzeigefläche an einer sichtbaren Oberfläche des Gehäuses. Optimiert wird die optische Wirkung der Kantenfläche und der Anzeigefläche durch Polieren derselben.

Bei einer weiteren erfindungsgemässen Ausgestaltung ist mit Vorteil eine Gehäusewand mit einer Nut versehen, deren Nutwand bzw. Nutwände als optisch wirksame Flächen fungieren, so dass auch hier seitlich einfallendes Licht unmittelbar in die Gehäusewand hineingebeugt wird. Die Lichtstrahlen verlaufen dann durch die Gehäusewand und parallel zu ihr bis zu einer von aussen gut einsehbaren Anzeigefläche des Gehäuses. Auch hier ist die Nutwand bzw. die Nutwände im Sinne einer optimalen Lichtbündelung entweder als schräge Fläche zur Gehäusewand ausgerichtet oder aber in Form einer konvexen Linse ausgestaltet. Selbstverständlich wird auch hier die optische Wirkung durch Polieren der Oberflächen verbessert.

Weitere Vorteile der Erfindung ergeben sich aus den Ansprüchen und der folgenden detaillierten Beschreibung, in der bevorzugte Ausgestaltungen unter Bezugnahme auf die Zeichnung im einzelnen erläutert sind. Dabei zeigt:

Fig. 1 eine perspektivische Darstellung eines erfindungsgemässen Gehäuses;

Fig. 2 eine Frontansicht des Gehäuses mit angedeutetem Schnitt A-A;

Fig. 3 eine Schnittdarstellung A-A nach Fig. 2 mit Lichtquellen, die gegenüber einer Gehäusekante angeordnet sind;

Fig. 4 a, b, c Schnittdarstellungen von Gehäuseteilen mit einer Lichtquelle, die neben einer Gehäusekante angeordnet ist, und

Fig. 5 a, b, c Schnittdarstellungen von Gehäuseteilen mit einer Lichtquelle, die neben einer Gehäusenut angeordnet ist.

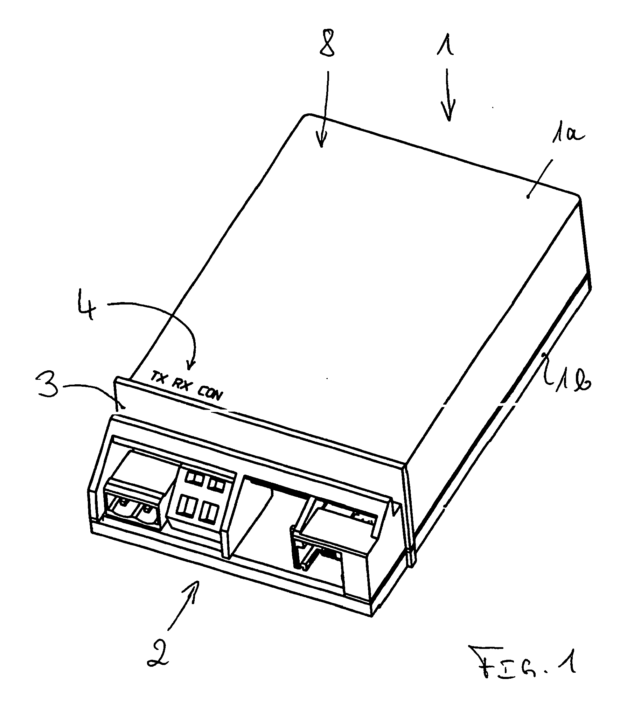

In Fig. 1 ist mit 1 ein Gehäuse für ein elektrisches oder elektronisches Gerät bezeichnet, dass aus einem Gehäuseoberteil 1a und einem Gehäuseunterteil 1b besteht. Eine Gehäusewand 3 des Gehäuseoberteils 1a schliesst das Gehäuse 1 gegen einen Anschlussbereich 2 des Geräts ab. Im Anschlussbereich 2 sind beispielsweise elektrische und/oder optische Anschlüsse vorgesehen, die hier nicht näher beschrieben werden. Das Gehäuse 1 weist eine sichtbare Oberfläche 8 auf, die auch dann für einen Betrachter einsehbar ist, wenn das Gerät funktionsbereit installiert ist.

Die sichtbare Oberfläche 8 ist mit einer nicht näher gezeigten Gehäusebeschriftung bedeckt, die zumindest in einem Anzeigebereich 4 Beschriftungen aufzeigt. Derartige Gehäusebeschriftungen werden auch Zifferblatt genannt. Auf einem solchen Zifferblatt ist vorliegend der Anzeigebereich 4 mit einer beispielhaften Beschriftung "TX RX CON" versehen. Diese Beschriftung ist charakteristisch für die Betriebsanzeige eines herkömmlichen Modems.

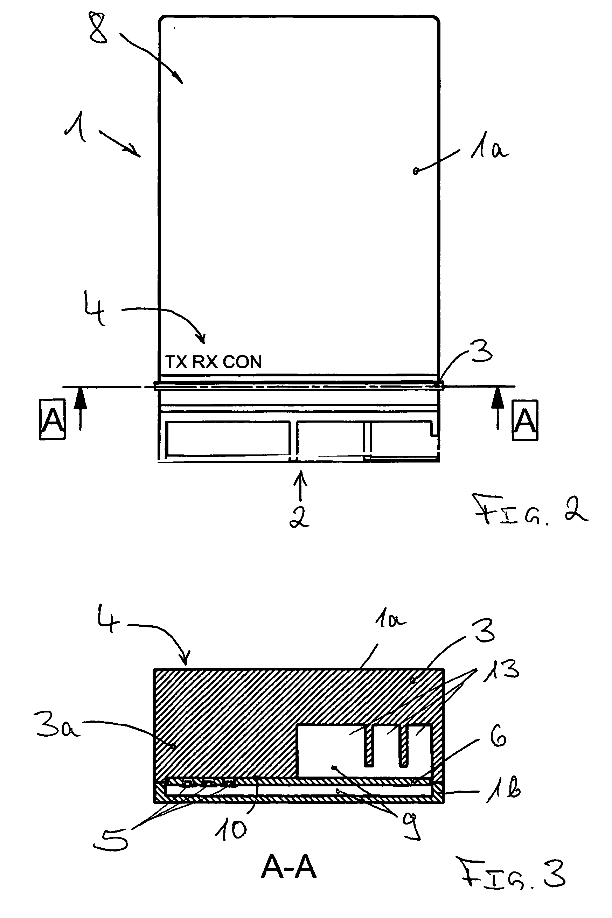

Fig. 2 zeigt die Oberfläche 8 des Gehäuses 1 mit dem beispielhaft beschrifteten Anzeigebereich 4 unmittelbar oberhalb der Gehäusewand 3, durch die mit einer gestrichelten Linie eine Schnittdarstellung A-A angedeutet wird. Fig. 3 zeigt den Schnitt A-A durch diese Gehäusewand 3. Zwischen dem Gehäuseoberteil 1a und dem Gehäuseunterteil 1b ist in einem Gehäuseinneren 9 eine Platine 6 installiert, die in der Nähe eines Gehäusewandteils 3a mit Leuchtdioden 5 (LEDs) als Lichtquelle bzw. Signalquelle ausgestattet ist. Diese LEDs 5 sind im Schnitt unmittelbar gegenüber einer Gehäusewandteilkante 10 auf der Platine 6 angeordnet, so dass ausgesendetes Licht von den LEDs 5 über diese Gehäusewandkante 10 in die Gehäusewand 3 eindringt. Die LEDs 5 sind dabei so angeordnet, dass ihre Signale der Beschriftung in Anzeigebereich 4 der Fig. 2 zugeordnet werden können.

Die Gehäusewand 3 weist in Fig. 3 zudem Ausnehmungen 13 auf, die der Bestückung mit nach aussen geführten Steckvorrichtungen dient. Diese werden hier keiner weiteren Betrachtung unterzogen.

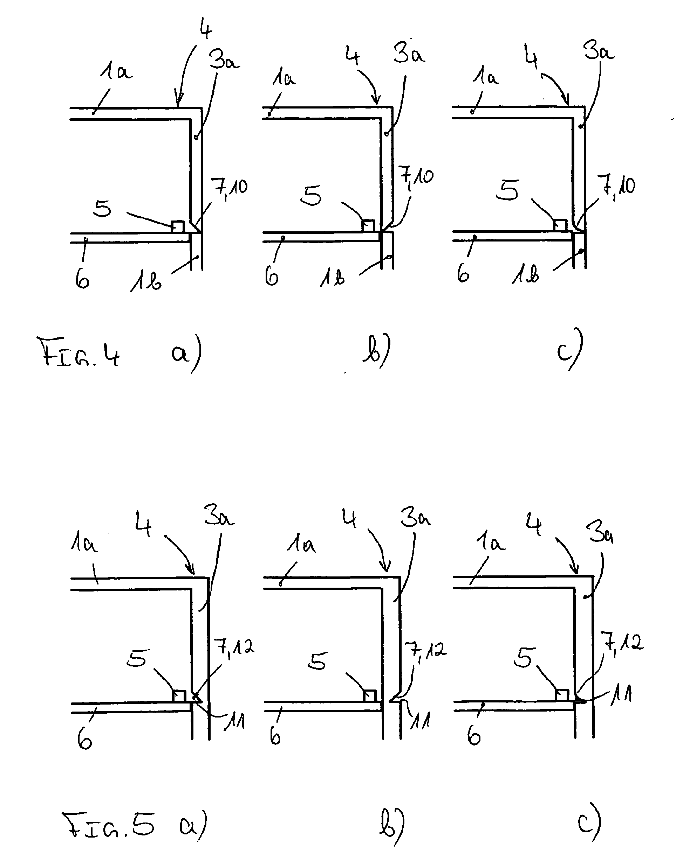

Die Fig. 4 a), b), c) zeigen in stark vereinfachter Schnittdarstellung die Anordnung einer LED 5 neben einem Gehäusewandteil 3a eines Gehäuseoberteils 1a. Neben dieser auf der Platine 6 installierten LED 5 weist das Gehäusewandteil 3a eine Gehäusewandteilkante 10 auf, die als optisch wirksame Fläche 7 ausgeführt ist. Das Gehäuseoberteil 1a schliesst mit der Gehäusewandteilkante 10 an ein Gehäuseunterteil 1b an.

Die Fig. 5 a), b), c) unterscheiden sich von den Fig. 4 a), b), c) im wesentlichen nur darin, dass eine LED 5 nicht im Stossbereich eines Gehäuseoberteils 1a und eines Gehäuseunterteils 1b sondern in unmittelbarer Nachbarschaft einer Nut 11 eines Gehäusewandteils 3a angeordnet ist. Diese Nut 11 umfasst eine Nutwand 12, die als optisch wirksame Fläche 7 ausgestaltet ist.
Wenn die LEDs in Fig. 3 Lichtsignale aussenden, so werden diese unmittelbar in den Gehäusewandteil 3a eingestrahlt und parallel zu diesem Gehäusewandteil 3a bis in den Anzeigebereich 4 geleitet. Die Gehäusewand 3 übernimmt somit die Funktion eines Lichtleiters. Die Lichtsignale der LEDs sind den Beschriftungen im Anzeigebereich 4 der Fig. 2 eindeutig zuordenbar.

Die Gehäuseteile 1a, 1b sind aus Kunststoff im Spritzgiessverfahren hergestellt. Um die Signale von im Gehäuseinneren 9 installierten LEDs an eine sichtbare Oberfläche 8 durch eine Gehäusewand 3 zu leiten, ist zumindest diese ganz oder teilweise aus einem transparenten Kunststoff hergestellt. Um eine optimale Lichtausbeute für die Signalisierung zu Erreichen, sind die Kantenfläche 10 (Fig. 3) und die Gehäusewand 3 in der Umgebung des Anzeigebereichs 4 poliert.

Die Fig. 4 a), b) c) zeigen eine Ausführungsvariante der Erfindung bei der Licht zunächst seitlich auf ein Gehäusewandteil trifft, wobei dieses Licht mit Auftreffen auf den Gehäusewandteil 3a mittels einer optisch wirkenden Fläche 7 in den Gehäusewandteil 3a gebrochen wird. Dort wird das Licht wieder parallel zum Gehäusewandteil 3a bis zu einem Anzeigebereich 4 geleitet. Die optisch wirkende Fläche ist in Fig. 4 a) als schräg zum Gehäusewandteil 3a angeordnete Gehäusewandteilkante 10 ausgeführt. Dabei ist diese schräge Gehäusewandteilkante 10 der zu ihr strahlenden LED 5 zugewandt.

In Fig. 4 b) ist die optisch wirkende Fläche 7 ebenfalls eine Gehäusewandteilkante 10, wobei diese Kante nun auf der der LED 5 abgewandten Seite des Gehäusewandteils 3a angeordnet ist. Eine weitere Variante ist in Fig. 4 c) gezeigt, bei der die optisch wirksame Fläche 7 als konvexe Gehäusewandteilkante 10 ausgeführt ist. Selbst wenn hier die konvexe Gehäusewandteilkante 10 der LED 5 zugewandt ist, so ist auch die weitere Ausführungsform denkbar, bei der die konvexe Gehäusewandteilkante auf der der LED 5 abgewandten Seite des Gehäusewandteils 3a angeordnete ist. Selbstverständlich ist auch eine Kombination aus den in den Fig. 4 a), b), c) gezeigten Ausführungsformen denkbar. Eine möglichst verlustfreie Lichtbündelung ist dann möglich, wenn jeweils die optisch wirksame Fläche 7 und der Anzeigebereich 4 poliert sind.

Für die Ausführungsformen nach den Fig. 5 a), b), c) gilt entsprechend das soeben zu den Fig. 4 a), b), c) gesagte mit dem Unterschied, dass in einem Gehäusewandteil 3a eine Nut 11 angeordnet ist, deren mindestens eine Nutwand 12 als optisch wirkende Fläche 7 entsprechen ausgestaltet ist.

Mittels der erfindungsgemässen Ausgestaltung von Gehäusewänden kann auf einfache Weise jedes gewünschte Lichtsignale einer im Gehäuseinneren installierten Lichtquelle an eine Gehäuseoberfläche transportiert und angezeigt werden. Herkömmliche reine "Anzeigeplatinen" für Lichtquellen unmittelbar unter einen Gehäusedeckel können genauso entfallen, wie Lichtleiter, die Signale aus der Gehäusetiefe an die Oberfläche transportieren.
- 1: Gehäuse
- 1a: Gehäuseoberteil
- 1b: Gehäuseunterteil
- 2: Anschlussfläche
- 3: Gehäusewand
- 3a: Gehäusewandteil
- 4: Anzeigebereich
- 5: Lichtquelle
- 6: Platine
- 7: optisch wirksame Fläche
- 8: sichtbare Oberfläche
- 9: Gehäuseinneres
- 10: Gehäusewandteilkante
- 11: Nut
- 12: Nutwand
- 13: Ausnehmung in 3

## Patentansprüche

1. Gehäuse (1) für ein elektrisches oder elektronisches Gerät, das an einer sichtbaren Oberfläche (8) einen Anzeigebereich (4) für eine Lichtquelle (5) aufweist, insbesondere zwecks Darstellung eines Zustands in einem zugehörigen Gehäuseinneren (9), wobei die Lichtquelle (5) auf einer Platine (6) im Gehäuseinneren (9) mechanisch angeordnet und elektrisch angeschlossen ist,
**dadurch gekennzeichnet,**
**dass** zwischen der Lichtquelle (5) und der davon beabstandeten sichtbaren Oberfläche (8) ein zumindest teilweise transparenter Gehäusewandteil (3a) angeordnet ist, durch den ausgesendetes Licht der Lichtquelle (5) im wesentlichen parallel zu diesem Gehäusewandteil (3a) leitbar ist.

2. Gehäuse nach Anspruch 1,
**dadurch gekennzeichnet,**
**dass** die Lichtquelle (5) gegenüber einer Gehäusewandkante (10) eines Gehäusewandteils (3a) angeordnet ist.

3. Gehäuse nach Anspruch 2,
**dadurch gekennzeichnet,**
**dass** die Gehäusewandteilkante (10) gegenüber der Lichtquelle (5) eine zumindest teilweise polierte Kantenfläche aufweist.

4. Gehäuse nach einem der vorhergehenden Ansprüche,
**dadurch gekennzeichnet,**
**dass** die sichtbare Oberfläche (8) eine zumindest teilweise polierte Anzeigefläche (4) aufweist.

5. Gehäuse nach Anspruch 1,
**dadurch gekennzeichnet,**
**dass** die Lichtquelle (5) seitlich zu dem Gehäusewandteil (3a) angeordnet ist, wobei das Gehäusewandteil (3a) zumindest teilweise eine optisch wirksame Fläche (7) aufweist, zwecks Brechung des eingestrahlten Lichts in dieses Gehäusewandteil (3a) im wesentlichen in Richtung parallel zu diesem Gehäusewandteil (3a).

6. Gehäuse nach Anspruch 5,
**dadurch gekennzeichnet,**
**dass** die optisch wirksame Fläche (7) eine zur Gehäusewand (3) schräg angeordnete Gehäusewandteilkante (10) ist.

7. Gehäuse nach einem der Ansprüche 5 oder 6,
**dadurch gekennzeichnet,**
**dass** die optisch wirksame Fläche (7) eine konvex ausgebildete Gehäusewandteilkante (10) ist.

8. Gehäuse nach Anspruch 5,
**dadurch gekennzeichnet,**
**dass** das Gehäusewandteil (3a) zumindest teilweise eine Nut (11) mit einer Nutwand (12) aufweist, die als eine optisch wirksame Fläche (7) ausgebildet ist.

9. Gehäuse nach Anspruch 8,
**dadurch gekennzeichnet,**
**dass** die optisch wirksame Fläche () der Nutwand () schräg zum Gehäusewandteil () angeordnet ist.

10. Gehäuse nach Anspruch 8,
**dadurch gekennzeichnet,**
**dass** die optisch wirksame Fläche () der Nutwand () konvex gewölbt ist.

## Claims

1. A housing (1) for an electrical or electronic apparatus, which on a visible surface comprises a display region (4) for a light source (5), in particular for the purpose of representing a condition in an associated housing interior (9), wherein the light source (5) is mechanically arranged and electrically connected on a circuit board (6) in the housing interior (9),
**characterized in that**
an at least partly transparent housing wall part (3a) is arranged between the light source (5) and the visible surface (8) distanced thereto, through which housing wall part (3a) the emitted light of the light source (5) may be led essentially parallel to this housing wall part (3a).

2. A housing according to claim 1,
**characterized in that**
the light source (5) is arranged opposite a housing wall edge (10) of the housing wall part (3a).

3. A housing according to claim 2,
**characterised in that**
the housing wall part edge (10) opposite to the light source (5) comprises an at least partly polished edge surface.

4. A housing according to one of the preceding claims,
**characterised in that**
the visible surface (8) comprises an at least partly polished display surface (4).

5. A housing according to claim 1,
**characterised in that**
the light source (5) is arranged laterally to the housing wall part (3a), wherein the housing wall part (3a) at least partly comprises an optically effective surface (7), for the purpose of refracting the beamed-in light into this housing wall part (3a) essentially in the direction parallel to this housing wall part (3a).

6. A housing according to claim 5,
**characterised in that**
the optically effective surface (7) is a housing wall part edge (10) arranged obliquely to the housing wall (3).

7. A housing according to one of the claims 5 or 6,
**characterised in that**
the optically effective surface (7) is a convexly formed housing wall part edge (10).

8. A housing according to claim 5,
**characterised in that**
the housing wall part (3a) at least partly comprises a groove (11) with a groove wall (12) which is designed as an optically effective surface (7).

9. A housing according to claim 8,
**characterised in that**
the optically effective surface (7) of the groove wall (12) is arranged obliquely to the housing wall part (3a).

10. A housing according to claim 8,
**characterised in that**
the optically effective surface (7) of the groove wall (12) is curved in a convex manner.

## Revendications

1. Boîtier (1) pour un appareil électrique ou électronique, lequel présente au niveau d'une surface visible (8) une zone de signalisation (4) pour une source lumineuse (5), en particulier pour la représentation d'un état dans un intérieur du boîtier (9) associé, la source lumineuse (5) étant disposée de manière mécanique sur une platine (6) à l'intérieur du boîtier (9) et étant raccordée électriquement,
**caractérisé en ce**
**qu'**entre la source lumineuse (5) et la surface visible (8) à distance de celle-ci, est disposé un élément de paroi de boîtier (3a) au moins partiellement transparent, à travers lequel on peut diriger de la lumière émise par la source lumineuse (5) de manière essentiellement parallèle à cet élément de paroi de boîtier (3a).

2. Boîtier selon la revendication 1,
**caractérisé en ce**
**que** la source lumineuse (5) est disposée en face d'une arête de paroi de boîtier (10) d' élément de paroi de boîtier (3a).

3. Boîtier selon la revendication 2,
**caractérisé en ce**
**que** l'arête de paroi de boîtier (10) présente en face de la source lumineuse (5) une surface d'arête au moins partiellement polie.

4. Boîtier selon l'une quelconque des revendications précédentes,
**caractérisé en ce**
**que** la surface visible (8) présente une surface de signalisation (4) au moins partiellement polie.

5. Boîtier selon la revendication 1,
**caractérisé en ce**
**que** la source lumineuse (5) est disposée latéralement par rapport à l'élément de paroi de boîtier (3a), l'élément de paroi de boîtier (3a) présentant au moins partiellement une surface à efficacité optique (7) pour la réfraction de la lumière d'irradiation dans cet élément de paroi de boîtier (3a) essentiellement en direction parallèle à cet élément de paroi de boîtier (3 a).

6. Boîtier selon la revendication 5,
**caractérisé en ce**
**que** la surface à efficacité optique (7) est une arête de paroi de boîtier (10) disposée en biais par rapport à une paroi de boîtier (3).

7. Boîtier selon l'une quelconque des revendications 5 ou 6,
**caractérisé en ce**
**que** la surface à efficacité optique (7) est une arête de paroi de boîtier (10) réalisée de manière convexe.

8. Boîtier selon la revendication 5,
**caractérisé en ce**
**que** l'élément de paroi de boîtier (3a) présente au moins partiellement une rainure (11) avec une paroi de rainure (12), laquelle est réalisée en tant que surface à efficacité optique (7).

9. Boîtier selon la revendication 8,
**caractérisé en ce**
**que** la surface à efficacité optique (7) de la paroi de rainure (12) est disposée en biais par rapport à l'élément de paroi de boîtier (3a).

10. Boîtier selon la revendication 8,
**caractérisé en ce**
**que** la surface à efficacité optique (7) de la paroi de rainure (12) est bombée de manière convexe.
